Europäisches Patentamt

European Patent Office

Office européen des brevets

(11) Veröffentlichungsnummer: **0 036 205**
A2

# (12) EUROPÄISCHE PATENTANMELDUNG

(21) Anmeldenummer: 81101947.0

(22) Anmeldetag: 16.03.81

(51) Int. Cl.³: **H 02 G 1/12**

(30) Priorität: 19.03.80 DE 3010586

(43) Veröffentlichungstag der Anmeldung:
23.09.81 Patentblatt 81/38

(84) Benannte Vertragsstaaten:
FR GB IT NL

(71) Anmelder: SIEMENS AKTIENGESELLSCHAFT Berlin
und München
Postfach 22 02 61
D-8000 München 22(DE)

(72) Erfinder: Bahnsen, Heiner, Ing. grad.
Martinistrasse 33
D-8900 Augsburg 21(DE)

(72) Erfinder: Granzer, Rudolf
Martin-Gomm-Weg 6
D-8900 Augsburg(DE)

(72) Erfinder: Kittel, Heinz
Dr.-Nebel-Strasse 8
D-8900 Augsburg(DE)

(72) Erfinder: Schorer, Werner
Alpenrosenstrasse 7
D-8900 Augsburg 21(DE)

(54) Verfahren zum Abisolieren von Reparatur- und Korrekturdrähten.

(57) Die Erfindung bezieht sich auf ein Verfahren zum Abisolieren von Reparatur-und Korrekturdrähten mit Hilfe eines Sandstrahlgebläses mit um die abzuisolierenden Drähte rotierendender Strahldüse. Beim Abisolieren von Korrektur- und Reparaturdrähten soll eine anschließende einwandfreie Verzinnung des abisolierten Drahtteils ermöglicht werden. Die Erfindung sieht hierzu vor, daß der verseilte Korrekturdraht (1) durch einen rotierenden Anschlag (2) aufgedrallt wird und daß als Strahlmittel Zinnbronze verwendet wird. Konzentrisch zum Korrekturdraht am Ende des aufgedrallten Teiles ist eine Sperrluftdüse (4) angeordnet, die als Luftsperre gegen eindringende Strahlpartikel im Außenmantel der verdrallten Drähte wirkt.

Croydon Printing Company Ltd.

SIEMENS AKTIENGESELLSCHAFT          Unser Zeichen
Berlin und München                  VPA
                                    80 P 2 0 2 0 E

Verfahren zum Abisolieren von Reparatur- und Korrekturdrähten.

Die Erfindung betrifft ein Verfahren zum Abisolieren von
Reparatur-und Korrekturdrähten mit Hilfe eines Sandstrahlgebläses mit um die abzuisolierenden Drähte
rotierender Strahldüse.

Bei der Änderungsverdrahtung von Baugruppen mit gedruckten
Leiterplatten werden zweifach verseilte polyimidbeschichtete 50 $\Omega$ Korrekturdrähte verarbeitet, deren Enden jeweils
2,5 mm verzinnt sein müssen. Zur Erzielung einer ausreichenden Lotbenetzung müssen diese Drahtenden abisoliert werden.
Da es sich bei der Weiterverarbeitung der Drähte um ein
kostenintensives Verfahren handelt, sind die Anforderungen
an die Abisolierqualität sehr hoch. Es ist bekannt, derartige Abisolierungen mit Hilfe von Sandstrahleinrichtungen
durchzuführen, wobei als Strahlmittel in der Regel Aluminiumoxid verwendet wird. Wegen der Agressivität des Strahlmittels ergeben sich dadurch stark verunreinigte Kupferoberflächen, so daß bei der nachfolgenden Ultraschallverzinnung nur eine teilweise Lotbenetzung erfolgt. Die Verunreinigung besteht dabei im wesentlichen aus eingeschossenen Aluminiumoxidpartikeln und Lackresten auf der Oberfläche des abisolierten Teils des Korrekturdrahtes.

Aufgabe der vorliegenden Erfindung ist es, ein Abisolierverfahren von Reparatur- und Korrekturdrähten anzugeben,
das eine anschließende einwandfreie Verzinnung des abisolierten Drahtteiles ermöglicht. Zur Lösung dieser Aufgabe wird gemäß der Erfindung derart verfahren, daß
der verseilte Korrekturdraht durch einen rotierenden Anschlag aufgedrallt wird, daß als Strahlmittel Zinnbronze
verwendet wird und daß konzentrisch zum Korrekturdraht

Zk 1 Fdl/ 10. 3. 1980

am Ende des aufgedrallten Teiles eine Sperrluftdüse angeordnet ist, die als Luftsperre gegen eindringende Strahlpartikel im Außenmantel der verdrallten Drähte wirkt.

Durch diese Maßnahmen verbleiben keinerlei Rückstände auf den abisolierten Drahtteilen. Auch die Lackisolation läßt sich damit restlos entfernen.

Zur weiteren Erhöhung der Abisolierqualität ist es vorteilhaft, wenn die Zinnbronze aus 90 % Kupfer und 10 % Zinn besteht, wobei die Körnung des Bronzepulvers etwa 70 $\mu$m betragen soll.

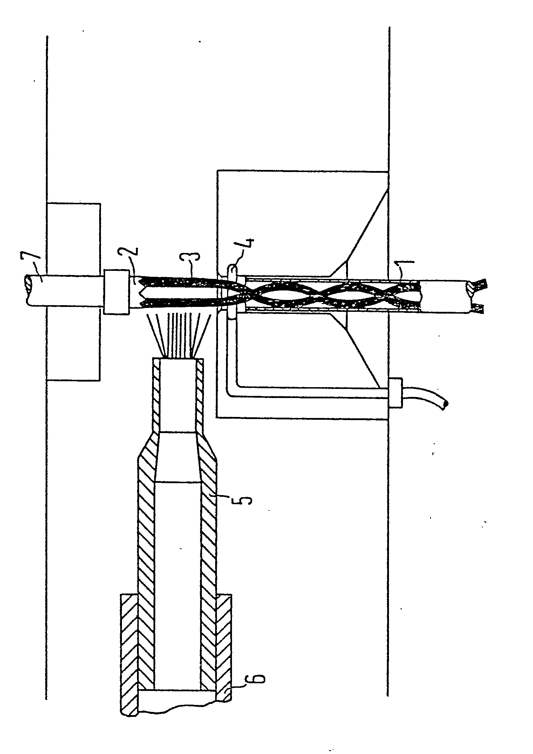

Anhand der Figur wird die Erfindung näher erläutert. Der zugeführte zweifach verseilte Korrekturdraht 1 wird mit Hilfe eines kronenhaft ausgebildeten rotierenden Anschlags 2 entdrallt. Das Strahlmittel wird über eine Strahldüse 5, die sich etwa 4 mm von dem abzuisolierenden Teil des Drahtes befindet, auf den Draht aufgesprüht. Dabei rotiert, wie an sich bekannt, die Strahldüse mit einstellbarer Geschwindigkeit um den abzuisolierenden Drahtteile 2. Am Ende der Düse ist ein Teil des Granulatflußschlauches 6 gezeigt, der Anschlag zum Entdrallen wird über einen Antrieb 7 gesteuert.

Eine Sperrluftdüse 4 ist konzentrisch zum Korrekturdraht 1 angeordnet, die Düsenöffnung sitzt ungefähr am Ende des entdrallten Teils 3 des Korrekturdrahtes 1. Beim Anstrahlen des Drahtes wird aus der Düse Sperrluft ausgeblasen, die eine Verschmutzung des Drahtes mit Bronzepulver verhindert. Der geometrische Aufbau des Anschlages zur Entdrallung bestimmt die Aufdrallänge und die damit verbundene Abisolierqualität zwischen den beiden Adern. Das Strahlmittel besteht dabei aus Zinnbronze mit einem Mischungsverhältnis von Kupfer zu Zinn von 9:1 und einer Körnung von ca. 70 $\mu$m. Der Rotationswinkel liegt bei etwa 400°. Die Abstrahlgeschwindigkeit ist entsprechend einstellbar. Durch diese Maßnahmen wird der negative Einfluß von Aluminiumoxid
auf der Kupferoberfläche und die damit verbundene
schlechte Lötbarkeit vollkommen ausgeschaltet und die
Abisolierqualität erheblich vergrößert.

1 Figur
3 Patentansprüche

-4-                          VPA    80 P 2 0 2 0 E

Patentansprüche

1. Verfahren zum Abisolieren von Reparatur- und Korrekturdrähten mit Hilfe eines Sandstrahlgebläses mit um die
abzuisolierenden Drähte rotierender Strahldüse, d a -
d u r c h   g e k e n n z e i c h n e t, daß der verseilte Korrekturdraht (1) durch einen rotierenden Anschlag (2) aufgedrallt wird, daß als Strahlmittel Zinnbronze verwendet wird und daß konzentrisch zum Korrekturdraht am Ende des aufgedrallten Teiles (3) eine Sperrluftdüse (4) angeordnet ist, die als Luftsperre gegen eindringende
Strahlpartikel im Außenmantel der verdrallten Drähte
wirkt.

2. Verfahren nach Anspruch 2, d a d u r c h   g e k e n n -
z e i c h n e t, daß die Zinnbronze aus 90 % Kupfer und
10 % Zinn besteht.

3. Verfahren nach Anspruch 3, d a d u r c h   g e k e n n -
z e i c h n e t, daß das Zinnbronzepulver eine Körnung
von 70 µm aufweist.